Europäisches Patentamt

European Patent Office

Office européen des brevets

Publication number: **0 269 112**

**A2**

# EUROPEAN PATENT APPLICATION

Application number: 87117497.5

Int. Cl.⁴: **C23C 14/02** , C23C 14/22

Date of filing: **26.11.87**

Priority: **27.11.86 JP 283809/86**

Date of publication of application:
**01.06.88 Bulletin 88/22**

Designated Contracting States:
**DE FR GB**

Applicant: **NISSIN ELECTRIC COMPANY, LIMITED**
**No.47, Umezu Takase-cho**
**Ukyo-ku Kyoto-shi Kyoto(JP)**

Inventor: **Ando, Yasunori c/o Nissin Electric Co.,Ltd.**
**No.47 Umezu Takase-cho**
**Ukyo-ku Kyoto-shi Kyoto(JP)**
Inventor: **Ogata, Kiyoshi c/o Nissin Electric Co.,Ltd.**
**No.47 Umezu Takase-cho**
**Ukyo-ku Kyoto-shi Kyoto(JP)**

Representative: **Patentanwälte Grünecker, Kinkeldey, Stockmair & Partner**
**Maximilianstrasse 58**
**D-8000 München 22(DE)**

**Method of forming a thin crystalline metal film.**

A method for depositing a thin metal film in a vacuum on a surface of a substrate which comprises the steps of:

(a) irradiating the surface of the substrate with a beam of ions of an inert gas or a metal, having a kinetic energy ranging from 100 eV to 1,000 eV; and

(b) depositing vaporized metal on the surface of the substrate, in which the ratio of the amount of ions irradiating the surface to the amount of vapor deposited on the surface ranges from about 0.5% to 30% and wherein the temperature of the substrate ranges from about room temperature to 500°C.

FIG. 2

EP 0 269 112 A2

# METHOD FOR FORMING A THIN CRYSTALLINE METAL FILM

## FIELD OF THE INVENTION

This invention relates to a method for forming a thin metallic film having good crystalline properties and. particularly to a method for forming a thin metallic film such as Al. Ti, V. Cr. Mn. Fe. Cu. Co. Ni. Zr. Nb. Mo. Hf, Ta. W, Au, Ag, In, and Sn, on a substrate by vapor deposition.

## BACKGROUND OF THE INVENTION

As a method for forming a thin metallic film on a base plate, there has been hitherto used (1) vacuum vapor deposition, (2) ion-plating method or (3) sputtering method. In every method thereof. a metallic material is scattered and deposited on a base plate in a vacuum vessel. According to the kind of metallic material, any one of said methods may be used as preferred. In every method. when the material is not heated at a high temperature, a thin metallic film having a good crystal properties can not be obtained.

The good crystal properties here, in a polycrystalline state, mean (i) an oriented crystal direction. (ii) a large crystal grain size, (iii) a little content of impurities etc. A thin crystalline film having the above crystal properties is stable in the physical and chemical properties, has a high mechanical strength and resists to corrosion.

When a specimen is kept at a temperature higher than several hundred degrees, i.e. higher than 500 -600°C, the thin metallic film is annealed to have good crystal properties. For a metal of higher melting point, the specimen should be heated to a higher temperature such as 800 - 1,000°C. Some specimens can not be used at such a high temperatures. For example, there is a case where a thin metallic thin film is formed on a semiconductor integrated circuit applied with a multi-layer wiring by means of heat diffusion, ion-injection, epitaxial growth, electrode formation and so on. In such case, when the specimen is heated to a high temperature, the diffusion of impurities progresses again and ions are drifted in the base plate. Further, the surface of epitaxial film may be occasionally roughed. In a three-dimensional device, the upper and lower laminate film may be melted occasionally into a united body. Such condition that a high temperature should be avoided is imposed on a base plate of integrated circuit. For example, some super conductive materials must not be exposed to a high temperature. Accordingly, it is highly required to provide a method through which a thin metallic film formed at room temperature is stable.

In the ion-plating or sputtering method, the degree of vacuum in the apparatus should be reduced to generate plasma. For example, it is $10^{-4}$ to $10^{-1}$ Torr. Therefore, the evacuation speed should be reduced. Thus, gas molecules adsorbed are not removed completely so that the molecules may enter into the thin metallic film, resulting in an impossibility of obtaining a thin metallic film of high purity.

The applicant has manufactured an apparatus for forming a thin film by simultaneously performing ion irradiation of vapor deposited material. The apparatus is vacuum apparatus comprising a vapor deposition apparatus and an ion embedding device.

In this apparatus, the component of an ion beam and the component of a material for vapor deposition are simultaneously directed to a base plate to form a thin film of a compound containing both of the components.

Examples of suitable ions for the ion beam include $N^+$, $C^-$, $Ar^-$ and the like. Also, as a material for vapor deposition, Ti, Si, B, Al and the like may be used.

Thus, by simultaneously performing the ion irradiation and the vapor deposition, a thin film of, for example, TiN, BN, AlN, and the like is formed. As the evaporating material, a metal is frequently used. For example, when Fe or Mo is used as the evaporating material. $N^+$ is used as the ion and a thin film of $Fe_x N$ or MoN is formed. Regarding the $Fe_x N$ compound, x can be a plurality of Fe atoms having various valences.

These thin films formed are physically and chemically stable thin compound films. For use on a base plate, a metal or an alloy is frequently used.

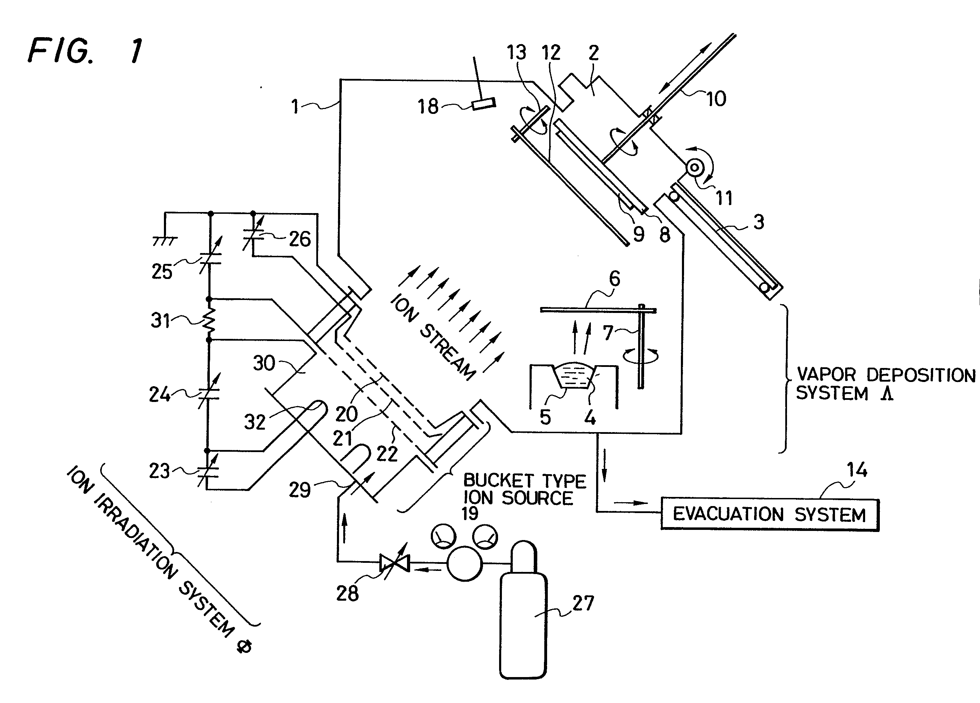

Apparatus for forming the ion vapor deposition thin film is known and is explained by referring to Fig. 1. Fig. 1 is a schematic sectional view showing the ion vapor deposition thin film forming apparatus.

An ion vapor deposition chamber 1 is a space capable of being evacuated. equipped with a vapor deposition system Λ and an ion irradiation system ο. In this apparatus, a vapor evaporation method for ion evaporation is not employed but rather a method of ion irradiation and vapor deposition.

At one side of the ion evaporation chamber is formed a preliminary chamber 2 which is a space for mounting and dismounting a specimen. The preliminary chamber 2 can be partitioned from the ion vapor deposition chamber 1 by a gate valve 3.

Under the ion vapor deposition chamber 1 is disposed a vapor deposition system A comprising an evaporation source 4, an evaporation source container 5, a vapor shutter 6 and a shutter axis 7. As the evaporation source 4, any ordinary evaporation material can be used such as Ti, Si, B or other various metals.

The heating method for the evaporation source and a vessel 5 differ according to the nature of the evaporation material. A resistance heating method or an electron beam heating method can be used. In the case of resistance heating, the evaporation source vessel 5 forms a heater composed of Ta, Mo, W or the like. Also, in the case of electron beam heating, the evaporation source vessel 5 is a crucible. In this apparatus, however an electron beam generating device and a magnet for bending and directing the electron beam to the evaporation source 4 are additionally required. However, they are omitted in Fig. 1 to simplifying the explanation.

Diagonally above the ion vapor deposition chamber 1 a specimen system is disposed. A specimen 9 is fixed to a holder 8 in such a manner that the surface thereof is directed diagonally downward. The holder 8 is supported by a specimen axis 10 which can be rotated and also can move in the axis direction. Thus, at the vapor deposition step, the specimen axis can be rotated to improve the uniformity of the film formation.

Also, in the case of mounting or dismounting the specimen 9, the specimen axis 10 is moved backward and the gate valve 3 is closed. Thus, the preliminary chamber 2 is isolated from the ion vapor deposition chamber 1. In this way, the ion vapor deposition chamber 1 can keep its vacuum state. Thereafter, the wall of the preliminary chamber 2 is pivoted around an opening and closing axis 11, whereby the holder 8 and the specimen 9 can be released outside the apparatus.

Furthermore, the specimen system is equipped with a specimen shutter 12 and a specimen shutter axis 13. The specimen shutter 12 is necessary for directing the ion stream and the stream of the evaporated material to the specimen 9 or shutting these streams off from the specimen 9. Also, a film thickness monitor 18 is disposed near the specimen 9.

The ion vapor deposition chamber 1 is connected to an evacuation system 14, whereby the inside of the ion vapor deposition chamber can be evacuated. An evacuation device may be independently equipped to the preliminary chamber 2.

Regarding the ion irradiation system, diagonally under the ion vapor deposition chamber 1 a bucket type ion source 19 is disposed which comprises screen-type electrodes 20, 21 and 22, an ion generating chamber 30, and a power source. In the ion generating chamber 30 is disposed a plurality of filaments 32 through which electric current is supplied by a filament power source 23.

A gas as an ion source is introduced into the ion generating chamber 30 through a valve 28 and a gas stream inlet 29 from a gas bomb 27. By an arc electric power source 24 and the filament power source 23, arc discharging occurs in the inside of the ion generating chamber 30. Many heated electrons are emitted from the filaments 32 which fly towards an anode, and which collide with the gas in the ion generating chamber 30 to energise the gas molecules to an excited state. Thus, a portion of the gas molecules becomes ionized due to the breaking the chemical bonds.

For example, when forming $N^+$ ions, ammonia gas ($NH_3$ gas) is introduced into the ion generating chamber 30. Likewise, when forming $C^+$ ions, methane gas ($CH_4$ gas) is introduced into the chamber. When an ion is originally obtained as simple substance, the gas of the atom for the ion is introduced into the chamber. For example, $O_2$ or an inert gas such as Ne, Ar, He or the like is simply introduced into the chamber as the gas thereof. However, since it is less desirable to form a compound of an inert gas, they are rarely introduced into the chamber.

The ions formed by the collision of electrons fill the ion generating chamber 30 and can be withdrawn from the chamber 30 by a drawing out electrode 25. The speed of the ions is reduced to a proper speed by a speed reducing power source 26 and electrodes 20 and 21. The ions which pass through the electrodes 20 to 22 fly towards the specimen 9 in an almost parallel ion stream.

In the bucket type ion source 19, there are shown gaps in the walls thereof, which means that each wall is electrically insulated form the other. However, these gap portions are airtightly formed so that the ion vapor deposition chamber can be evacuated without any difficulty.

The drawing out power source 25 is connected to the arc electric source 24 by a resistance 31 so that the levels of the arc electric source 24 and the filament power source 23 are not raised.

The accelerating voltage of the ion beam is from 10 KV to 40 KV so that the ions attain a high stream speed having a kinetic energy of from 10 KeV to 40 KeV. The ion irradiation and the vapor deposition are carried out in a vacuum ranging from about $10^{-6}$ to about $10^{-4}$ Torr. The ion electric current is from about several mA to about 10 mA. Also, the beam size is from 30 mm to 150 mm. The beam size can be optionally selected by electrodes 20 to 22.

The power of the evaporation source depends upon the nature of the vapor evaporation material and can range from about 2KV to 10 KV.

The above-described apparatus is the general feature of the ion vapor deposition thin film forming apparatus previously manufactured by the applicant.

Turning to its operation, the specimen axis is pulled up, the gate valve 3 is closed and the cover is opened. Then, the specimen 9 is mounted on the holder 8. The specimen may be selected from metals. dielectrics, semiconductor base plates and the like.

For example, for making TiN coating, $N_2$ gas or $NH_3$ gas is introduced into the ion generating chamber to generate $N^+$ ion and Ti is sputtered from the evaporation source of Ti. Also, for making a MoN coating. the $N^+$ ion irradiation and the vapor deposition of Mo are simultaneously carried out. The coatings of $Fe_xN$. AlN, BN or the like can be formed in the same manner. In any event irradiation of $N^-$ ion and the vapor deposition of Fe, Al, B and the like, form strong coatings of $Fe_xN$, AlN, and BN.

This ion vapor deposition thin film forming method has the following benefits:

(1) New material can be formed

Since the aforementioned apparatus has excellent controlling faculty, the ion irradiation and the vapor deposition can be separately applied. Also, in the apparatus, each element can be optionally elected and various kinds of ions and vapor evaporating materials can be simultaneously or alternately applied to the surface of a specimen. Thus, a thin film of a new material can be formed on a specimen;

(ii) A thin film having excellent adhesion can be formed

Since in the aforementioned apparatus, the ion irradiation is applied onto a specimen by ions having a high energy ranging from about 10 KeV to 40 KeV, the ion itself and a vapor evaporation element become imbedded into a base plate specimen. The high-speed ions destroy a part of the structure of the base plate to form a transitional layer composed of the element of the base plate, ions and the element of the vapor deposited material. The layer is called a mixing layer. On the mixing layer, a thin compound layer comprising the ion and the element of the vapor deposited material is formed. Due to formation of the thin compound layer on the mixing layer, a strong thin film having excellent adhesion with the base plate is formed. This is the overall effect obtained when the kinetic energy of the ion ranges from about 10 KeV to 40 KeV. This is quite different from a simple vapor deposition method wherein the surface of the base plate is not changed and a polycrystalline layer of the vapor deposited element is merely formed thereon;

(iii) Since the ion beam has a large cross-sectional area, a uniform film can be formed

This apparatus employs a bucket type ion source, multi filaments and multi electrodes (multi apertured). Thus, even with an ion beam having a large sectional area, the uniformity of the thin film formed is with ± 15%.

## SUMMARY OF THE INVENTION

The object of this invention is to provide a method for forming a thin metallic film having an excellent crystal property, at a low temperature without exposing a specimen to a high temperature.

As previously discussed, the aforementioned conventional ion vapor deposition method forms a strong thin film of a compound AB, wherein A represents an ion atom and B represents a vapor deposition atom. The formation of such a compound is based on the condition that the atom A and the atom B are atoms capable of forming a compound. It is additionally required that the ion attain a high kinetic energy ranging from about 10 KeV to 40 KeV. For example, when the kinetic energy of N, having a mass number of 14, is 10 KeV the speed thereof becomes 370 Km/sec. Since the ions have such a high kinetic energy, a mixing layer is formed and compound AB is formed in a stable state.

Attempting to improve the crystalline properties of the vapor deposited film of metal, inventors used the aforesaid apparatus in a different manner. That is, the investigation is for vapor depositing metal but not for forming a compound of metal. In furtherance of this, a material having poor reactivity was selected as the ion. However, it has been found that the selection of a poor reactive material only, proved unsatisfactory. That is because if the energy for striking the ion is high. even an atom having poor reactivity becomes embedded in the thin film of metal and cannot diffuse out.

If the temperature is sufficiently high. the atoms may completely diffuse out of the thin film since atoms having poor reactivity cause elastic collision. However, as described hereinbefore, it is important to not increase the temperature of specimen to a degree where the electronic device becomes deteriorated.

As a result of these considerations and investigations. the inventors have discovered that a vapor-

0 269 112

deposited thin metallic film can be strongly formed if it is irradiated by ions of an inert gas at a low energy. Advantageously, the crystalline properties of the metallic film are enhanced, which can be attributed to the increase in the crystal grain size and the uniform arrangement of the crystal orientations.

IFurthermore, it has been found that the optimum kinetic energy of inert gas ions is from 100 eV to 1.000 eV, which is from 1 10 to 1 400 of the 10 KeV to 40 KeV used in the conventional ion vapor deposition method. It is important in the practice of the present invention that the kinetic energy of the ions is low.

In the present invention, an inert gas such as Ne, Ar, or He can be used. Furthermore. metal itself can be also used as the ion. When the metal ion is used, the metallic film advantageously contains no foreign elements. However, some metals may be ionized difficulty, so that an ion stream of metal is not always used.

According to the method, a stable thin metallic film may be formed and the temperature of the specimen is sufficiently from room temperature to 500°C. In many cases, it is sufficient from room temperature to 300°C and even at room temperature, a thin film of good property may be obtained. Such a low temperature of specimen according to this invention greatly improves the conventional method in which the temperature of the specimen should be kept at a temperature above 500°C in order to make a thin metallic film stable.

Thus, the method of the present invention comprises the steps of:

(a) Irradiating the surface of the substrate with a beam of ions of an inert gas or a metal, having a kinetic energy ranging from 100 eV to 1,000 eV, and

(b) Depositing vaporized the metal on the surface of the substrate, wherein the ratio of the amount of ions irradiating the surface to the amount of vapor deposited on the surface ranges from about 0.005 to 0.3 and wherein the temperature of the substrate ranges from about a room temperature to 500°C. the metal comprising any one of Al, Ti, V, Cr, Mn. Fe, Cu, Co, Ni, Zr, Nb, Mo. Hf, Ta, W, Au, Ag, In, Sn or the like.

## BRIEF DESCRIPTION OF DRAWINGS

Fig. 1 is a section view of the apparatus for forming a thin film of ion vapor deposition, which has been accomplished by the applicant. This apparatus is known and this invention can be carried out by means of the apparatus;

Fig. 2 is a diagram showing the relationship between the scattering angle $2\theta$ and the diffraction intensity obtained by the X-ray diffraction of Al thin film according to examples of this invention; and

Fig. 3 is a diagram showing the relationship between the ion electric current I and the value of I-(1,1,1)/I(2,0,0) in the Al thin film.

## DETAILED DESCRIPTION OF THE INVENTION

The present invention is described in greater detail below. First, the ion energy $E_i$ is from 100 eV to 1,000 eV. When a monovalent ion having a mass of m is accelerated at V volts and the initial velocity is 0, there is a relation of

$$E_i = \frac{1}{2} m v^2 = e V \ldots\ldots\ldots\ldots (1)$$

wherein v is the final speed.

For the ion having a mass number M

$$v = \sqrt{\frac{2eV}{M m_0}} \ldots\ldots\ldots\ldots\ldots (2)$$

wherein $m_0 = 1.66 \times 10^{-27}$ Kg which is the mass of one atomic weight. and $e = 1.6 \times 10^{-19}$ C.

5

$$v = 13.8 \times \sqrt{\frac{V}{M}} \; Km/sec. \; \ldots\ldots\ldots (3)$$

Since the mass numbers of Ne. Ar and He are 20.2. 40.0 and 4.0 respectively. the speeds of them corresponding to the accelerating voltages V = 100 V and 1,000 V are as follows:

|     | 100 V | 1,000 V |
|-----|-------|---------|
| Ne  | 30.7 Km/sec. | 97 Km/sec. |
| Ar  | 21.8 Km/sec. | 69 Km/sec. |
| He  | 69 Km/sec. | 218 Km/sec. |

These speeds are sufficiently low.

When the acceleration voltage is higher than 1.000 v, these ions enter deeply into the thin metallic film and buried therein. When the atoms of inert gas remain in the thin film, the electric conductivity of the film is reduced undesirably, and the crystallization is prevented. so that the heat conductivity is also reduced. Thus, the acceleration voltage is necessarily less than 1,000 V.

To the contrary, when the acceleration voltage is less than 100 V, the crystal properties of metallic film of vapor deposition are not improved.

The ratio $\Upsilon$ of the flux Q of the ion stream to the flux W of the evaporated component is explained, which corresponds to the condition (b) as mentioned above.

The ratio of ion/deposition is defined as follows:

$$.\Upsilon = \frac{Q}{W} \; \ldots\ldots\ldots\ldots\ldots (4)$$

The condition (b) requires the relation of $0.005 \leq \Upsilon \leq 0.3$. This may be shown by means of the vapor deposition speed v and the ion electric surrent I

When the density of solid metal is p, the vapor deposition speed is v, the Avogadro's Number is $L_o$ and the mass number of metal is $M_o$, the flux (W) of evaporated component is given by the following equation:

$$W = \frac{\rho v L_o}{M_o} \; \ldots\ldots\ldots\ldots\ldots (5)$$

When the ion electric current is I, the electric charge of ion is q and the section area of ion stream is S, the flux (Q) of ion stream is given by the following equation:

$$Q = \frac{I}{qS} \; \ldots\ldots\ldots\ldots (6)$$

The ratio $\Upsilon$ of ion/deposition is given by the following:

$$\Upsilon = \frac{1}{v}\left(\frac{M_o}{q\rho L_o S}\right) \; \ldots\ldots\ldots (7)$$

For a monovalent ion. the electric charge of ion $q = 1.6 \times 10^{-19} C$ and $L_o = 6.02 \times 10^{23}$ and so.

$$T = 1.04 \times 10^{-5} \frac{I M_0}{\upsilon \rho S} \dots \dots (8)$$

For aluminum. $M_0 = 27.0$ and $\rho = 27$ g/cm³ and so,

$$T(Al) = 1.04 \times 10^{-4} \frac{I}{\upsilon S} \dots \dots (9)$$

Similarly, for Cu, Ag, Au, Ni, Co, and Ti,

$$T(Cu) = 0.74 \times 10^{-4} \frac{I}{\upsilon S} \dots \dots (10)$$

$$T(Ag) = 1.07 \times 10^{-4} \frac{I}{\upsilon S} \dots \dots (11)$$

$$T(Ni) = 0.69 \times 10^{-4} \frac{I}{\upsilon S} \dots \dots (12)$$

$$T(Co) = 0.69 \times 10^{-4} \frac{I}{\upsilon S} \dots \dots (13)$$

$$T(Ti) = 1.1 \times 10^{-4} \frac{I}{\upsilon S} \dots \dots (14)$$

For other metals, the equation may be given easily. After all, the condition (b) is shown by the following equation:

$$480 \leq \frac{I M_0}{\upsilon \rho S} \leq 28800 \; (coulombs) \dots \dots (15)$$

When $\Upsilon$ is less than 0.005, i.e. less than 0.5%, the ion beam is too weak and the crystal properties are not improved. On the other hand, when $\Upsilon$ is more than 0.3, i.e. more than 30%, there is a possibility that the atoms of inert gas remain in the thin metallic film. Accordingly, $0.5\% \leq \Upsilon \leq 30\%$ in this invention.

The thickness of thin metallic film formed according to this invention is within the range of from 500 Å to several $\mu$m and this invention may be used for forming a thin film having a thickness which is usually called as thin film. When the thickness is over 10 $\mu$m, the film is liable to be separated from the base plate undesirably.

When an electric current is passed through a thin metallic film, an electromigration is occurred, whereby the thin film is deteriorated and its life is reduced. The mean life MTF of the thin film depending on the electromigration has an intimate relation to the crystal properties.

The crystal properties of a thin metallic film can be determined by X-ray diffraction. The thin metallic film is polycrystalline and contains crystal grains of various orientations.

The spacing d of planes having plane indexes of $l$, $m$ and $n$ is given by the following equation:

$$d = \frac{1}{\sqrt{l^2 + m^2 + n^2}} \dots \dots (16)$$

When the wave length of X-ray is λ. the diffraction angle $\theta(l, m, n)$ to a plane $(l, m, n)$ is determined from the condition of Bragg's diffraction:

$$2\,d\sin\theta = \lambda \ldots\ldots\ldots\ldots (17)$$

The intensity of diffracted X-ray to the diffraction angle $\theta$ is shown by $I(l, m, n)$. The large intensity means the presence of many crystal grains having the plane $(l, m, n)$.

The diffraction intensity $I(\theta)$ to $\theta$ is determined. The correspondence between $\theta$ and $(l, m, n)$ may be shown by the equations (11) and (12), so that $I(l, m, n)$ can be obtained from the result of X-ray diffraction.

For the thin film of aluminum the life MTF determined by the deterioration resulted from the electromigration may be evaluated approximately by the following equation;

$$MTF = K \cdot \log \frac{I(1,1,1)}{I(2,0,0)} \ldots\ldots\ldots\ldots (18)$$

wherein K is a constant. That is. when $I(1, 1, 1)$ is high. the electromigration is occurred difficultly. Accordingly, the ratio of $I(1, 1, 1)/I(2, 0, 0)$ may be used for the evaluation of crystal properties. The electromigration may occur hardly at a large value of said ratio, i.e. the thin film is stable physically and chemically.

In general, the ratio of $I(1, 1, 1)/I(2, 0, 0)$ of an aluminum thin film formed by vapor deposition is said to be about 2. Aluminum forms a face centered cubic lattice and has a gliding plane $(1, 1, 1)$. Therefore, it may be thought that the crystal structure will be stable when grains having the surface of plane $(1, 1, 1)$ are increased. Though the equation (18) is an empirical equation, the same equation may be given to Cu, Ag, Au, and Ni because these metals are also face centered cubic and have a gliding plane $(1, 1, 1)$.

Example 1

Aluminum was deposited on a silicon wafer having a plane $(1, 1, 1)$ according to this invention. As ion beam, a beam of Ne ions was used. Conditions were as follows:
Al vapor deposition speed v = ca. 5 Å/sec.
Ne ion acceleration energy = 500 eV
Temperature of Si wafer $T_o$ = room temp.

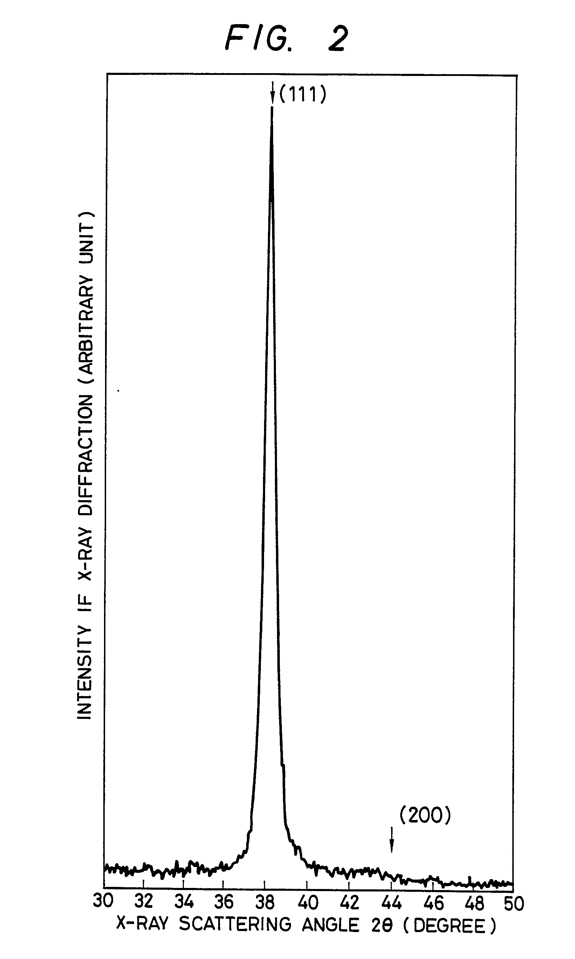

The crystal structure of the resulting Al thin film was studied by X-ray diffraction. Fig. 2 shows a diagram relating to the relationship between the intensity of X-ray diffraction and the diffraction angle distribution in the thin film which was formed at an ion electric current of 4 mA. A peak of intensity is seen at a scattering angle $2\theta = 38°$. This is the scattering by the plane $(1, 1, 1)$. On the other hand, the scattering due to the plane $(2, 0, 0)$ is seen in the vicinity of 44° disappearing the peak. This means very small number of crystal grains having the plane $(2, 0, 0)$ and a large number of crystal grains having the plane $(1, 1, 1)$ and being oriented.

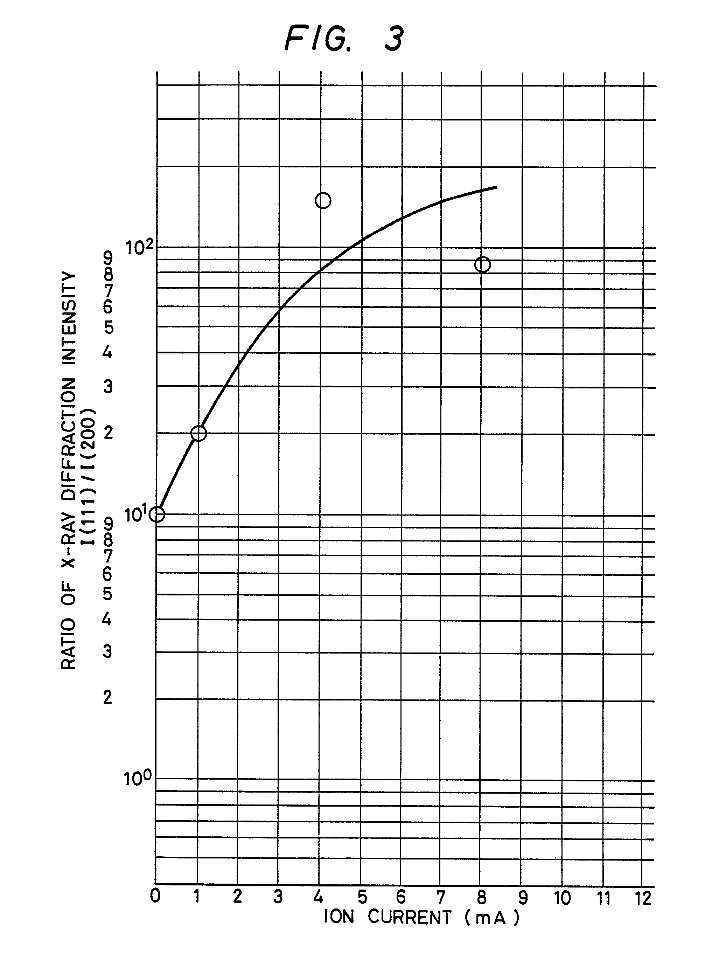

The value of ion electric current was then varied and the value of $I(1, 1, 1)/I(2, 0, 0)$ was determined. The results are shown in Fig. 3 in which the ion electric current is shown on the axis of abscissa. When the ion electric current is increased, the ratio of $I(1, 1, 1)/I(2, 0, 0)$ is also increased. It has been found that several % of Ne atoms are contained in the film at room temperature and I = 8 mA. No Ne atom was found in Al at room temperature and I = 4 mA. No Ne atom was burried in Al at V = 500V and I = 8 mA when the temperature of specimen was 300°C.

As described above, the following benefits were unexpectedly obtained by the method of this invention.

(1) A physically and chemically stable thin metallic film can be obtained. Annealing at a high temperature is not necessary and the treatment at a low temperature is carried out.

(2) Since a specimen is hardly heated, so that the method according to this invention is most suitable for the formation of thin metallic film on a specimen such as semiconductor integrated circuit and super conducitve material etc.

(3) The metal is not strengthened by means of impurities, so that a thin metallic film of almost pure metal may be obtained resulting in many applications. The reduction of the electric conductivity and heat conductivity are not occurred which are resulted by the addition of impurities.

In an attempt to explain the unexpected improvement in the quality of the metal film produced from vacuum vapor depositing metal while irradiating with inert gas ion or the metal ion. the following explanations have been preferred.

(1) Absorbed gases such as $O_2$, $N_2$. $H_2O$ etc., from the surrounding atmosphere are scattered off by ions and the surface of a specimen is kept clean.

(2) Since ions collide to atoms on the surface of the specimen. the atoms are activated to an excited state. By the energy interchange between the atoms at the surface of the specimen and the metal atoms. the metal atoms become movable on the surface of the specimen to minimize the free energy thereof. When the atoms move to a stable position. a strong structure must be formed.

(3) By the energy interchange between the ion on the surface of the specimen and the metal ions. the metal ions obtain energy and become diffusible in the surface of the specimen.

Additional advantages and modifications will readily occur to those skilled in the art. The invention in its broader aspects is, therefore, not limited to the specific details, and illustrative examples shown and described. Accordingly, departures may be made from such details without departing from the spirit or scope of the general inventive concept as defined by the appended claims and their equivalents.


## Claims

1. A method for forming a thin metal film in a vacuum on a surface of a substrate, said method comprising the steps of:

irradiating said surface of said substrate with a beam of ions of an inert gas or a metal, said ions having a kinetic energy ranging from 100 eV to 1,000 eV; and

depositing vaporized said metal on said surface of said substrate wherein the ratio of the amount of said ions irradiating said surface to the amount of vapor deposited on said surface ranges from about 0.005 to 0.3 and wherein the temperature of said substrate ranges from about a room temperature to 500°C.

2. A method for forming a thin metal film as claimed in Claim 1, wherein said metal is selected from the group comprising Al, Ti, V, Cr, Mn, Fe, Cu, Co, Ni, Zr, Nb, Mo, Hf, Ta, W, Au, Ag, In and Sn.

3. A method for forming a thin metal film as claimed in Claim 1, wherein said inert gas is selected from the group comprising Ne, Ar and he.

4. A method for forming a thin metal film as claimed in Claim 1, wherein said irradiating and depositing steps are formed simultaneously.

5. A method for forming a thin metal film as claimed in Claim 1, wherein said temperature of said substrate ranges from about room temperature to 300°C.

# FIG. 1

VAPOR DEPOSITION SYSTEM A

EVACUATION SYSTEM

ION STREAM

BUCKET TYPE ION SOURCE 19

ION IRRADIATION SYSTEM Φ

1, 2, 3, 4, 5, 6, 7, 8, 9, 10, 11, 12, 13, 14, 18, 20, 21, 22, 23, 24, 25, 26, 27, 28, 29, 30, 31, 32

## FIG. 2

## FIG. 3

RATIO OF X-RAY DIFFRACTION INTENSITY I(111) / I(200)

ION CURRENT (mA)